# EUROPEAN PATENT APPLICATION

(11) **EP 4 797 776 A1**
(43) Date of publication of application: **26.08.2026**
(21) Application number: 24884207.2
(22) Date of filing: 30.08.2024
(51) Int. Cl.: H04W 24/06, G06F 30/20

(54) **DIGITAL TWIN NETWORK CONSTRUCTION METHOD, APPARATUS, DEVICE AND STORAGE MEDIUM**

(30) Priority: 30.10.2023 CN 202311424327
(71) Applicant: CHINA MOBILE COMMUNICATION CO., LTD RESEARCH INSTITUTE, Beijing 100053 (CN); CHINA MOBILE COMMUNICATIONS GROUP CO., LTD., Beijing 100032 (CN)
(72) Inventor: LI, Qin, Beijing 100032 (CN); LI, Weiyuan, Beijing 100032 (CN); LIAN, Yue, Beijing 100032 (CN)
(74) Representative: Novagraaf Technologies
(86) International application number: PCT/CN2024/115679
(87) International publication number: WO 2025/092200

(57) **Abstract**

Provided in the embodiments of the present disclosure are a digital twin network construction method, an apparatus, a device and a storage medium. The method comprises: an orchestration function receives a first request sent by a consumer, the first request being used for requesting construction of a digital twin network, and the first request comprising related information of the digital twin network; the orchestration function performs analysis on the basis of the first request and network deployment information, and generates an orchestration result of a digital twin network instance; and the orchestration function sends the orchestration result to a control function, such that the control function performs control on the digital twin network instance on the basis of the orchestration result, the control comprising at least one of the following control over the digital twin network instance: deployment, configuration, starting and state monitoring.

## Description

### CROSS REFERENCE TO RELATED APPLICATIONS

This application claims priority to Chinese Patent application No. 202311424327.7, filed on October 30, 2023, the content of which is hereby incorporated by reference in its entirety.

### TECHNICAL FIELD

The present disclosure relates to the technical field of communication, and in particular to a method, an apparatus, a device, and a storage medium for digital twin network construction.

### BACKGROUND

The currently provided method of digital twin network construction generally constructs a complete digital twin network, which includes collecting data from physical network, storing the data, then modeling the network object and topology based on the collected data, and finally generating the complete network digital twin entity based on the model. The digital twin entity can interact with and control the physical network in real time, and the network optimization strategy can be pre-verified in the digital twin network and then sent to the physical network, thus improving the accuracy and reliability of network optimization.

However, the current approach of constructing a complete digital twin network by uniformly collecting data does not fully consider the real-time requirements of data collection and network simulation when the digital twin network mirrors real-time services of the physical network. It is feasible to collect and train data uniformly during the offline modeling stage of digital twin network. However, during the real-time simulation stage, the centralized digital twin network platform cannot meet the mirroring requirements of real-time network and services.

### SUMMARY

In order to solve the existing technical problems, an embodiment of the present disclosure provides a method, a device, an apparatus, and a storage medium for digital twin network construction.

To this end, the technical solutions of embodiments of the disclosure are implemented as follows.

In a first aspect, an embodiment of the present disclosure provides a method for digital twin network construction, the method is applied to an orchestration function, and the method includes:

the orchestration function receives a first request sent by the consumer. The first request is used for requesting construction of a digital twin network, and the first request includes relevant information of the digital twin network;

the orchestration function performs analysis based on the first request and network networking information to generate an orchestration result of digital twin network instance(s); and

the orchestration function sends the orchestration result to a control function to cause the control function to perform control of the digital twin network instance(s) based on the orchestration result, the control comprising at least one of following controls for the digital twin network instance(s): deployment, configuration, initiation, or status monitoring.

In the above solution, the method further includes that the orchestration function receives a second request sent by the consumer, and sends the second request to the control function, the second request being used for requesting deletion of the digital twin network instance(s).

In the above solution, the digital twin network instance(s) comprises: digital twin network function instance(s) and data collection and processing instance(s).

The orchestration result comprises: at least one digital twin network function instance, at least one data collection and processing instance, and at least one of following: a connection relationship and interaction relationship between the digital twin network function instance(s), a connection relationship and interaction relationship between the data collection and processing instance(s), and a connection relationship and interaction relationship between the digital twin network function instance(s) and the data collection and processing instance(s).

In a second aspect, an embodiment of the present disclosure provides a method for digital twin network construction, the method is applied to an orchestration function, and the method includes:

the control function receives an orchestration result of digital twin network instance(s) sent by an orchestration function, and performs control of the digital twin network instance(s) based on the orchestration result. The control comprises at least one of following for the digital twin network instance(s): deployment, configuration, initiation, or status monitoring.

In the above solution, the digital twin network instance(s) comprises: digital twin network function instance(s) and data collection and processing instance(s).

The orchestration result comprises: at least one digital twin network function instance, at least one data collection and processing instance, and at least one of following: a connection relationship and interaction relationship between the digital twin network function instance(s), a connection relationship and interaction relationship between the data collection and processing instance(s), and a connection relationship and interaction relationship between the digital twin network function instance(s) and the data collection and processing instance(s).

In the above solution, the operation that the control function performs deployment of the digital twin network instance(s) based on the orchestration result comprises: the control function obtains twin model(s) corresponding to the digital twin network instance(s) based on the orchestration result, and determines deployment position(s) of the digital twin network instance(s).

The control function deploys the digital twin network instance(s) according to the deployment location(s) and the twin model(s).

In the above solution, the operation that the control function performs configuration of the digital twin network instance(s) based on the orchestration result comprises: the control function configures at least one of the following to the digital twin network instance(s) based on the orchestration result:
a connection relationship and interaction relationship between the digital twin network instance(s); or
attribute information of data collection processing instance(s).

In the above solution, the operation that the control function performs initiation of the digital twin network instance(s) based on the orchestration result comprises: the control function sends a first instruction to the digital twin network instance(s), and the first instruction is used to initiate the digital twin network instance(s).

In the above solution, the operation that the control function performs status monitoring of the digital twin network instance(s) based on the arrangement result comprises: the control function obtains status information sent by the digital twin network instance(s), and monitors status of the digital twin network instance(s) based on the status information.

In the above solution, the method further comprises: the control function receives a second request sent by the orchestration function, the second request being used for requesting deletion of the digital twin network instance(s).

The control function sends a second instruction to the digital twin network instance(s). The second instruction is used to stop running the digital twin network instance(s) and reclaim resource(s) of the digital twin network instance(s).

In a third aspect, an embodiment of the present disclosure provides an apparatus for digital twin network construction, the method is applied to an orchestration function, and the apparatus includes a first communication unit and a first processing unit.

The first communication unit is configured to receive a first request sent by the consumer. The first request is used for requesting construction of a digital twin network, and the first request comprises relevant information of the digital twin network.

The first processing unit is configured to perform analysis based on the first request and network networking information to generate an orchestration result of digital twin network instance(s).

The first communication unit is further configured to send the orchestration result to a control function to cause the control function to perform control of the digital twin network instance(s) based on the orchestration result, the control comprising at least one of following controls for the digital twin network instance(s): deployment, configuration, initiation, or status monitoring.

In a fourth aspect, an embodiment of the present disclosure provides an apparatus for digital twin network construction, the method is applied to a control function, and the apparatus includes a second communication unit and a second processing unit.

The second communication unit is configured to receive the orchestration result of the digital twin network instance(s) sent by the orchestration function.

The second processing unit is configured to perform control of the digital twin network instance(s) based on the orchestration result, the control comprising at least one of following for the digital twin network instance(s): deployment, configuration, initiation, or status monitoring.

In a fifth aspect, an embodiment of the present disclosure provides a computer-readable storage medium, in which a computer program is stored. When the program is executed by a processor, steps of the method for digital twin network construction described in the above first aspect or second aspect of the embodiment of the present disclosure are implemented.

In a sixth aspect, the embodiment of the present disclosure further provides a network function, including a memory, a processor, and a computer program stored in the memory and executable by the processor. When the program is executed by the processor, the steps of the method for digital twin network construction described in the above first aspect or second aspect of the embodiment of the present disclosure are implemented.

The method, apparatus, device and storage medium for digital twin network construction provided by the embodiment of the present disclosure propose an orchestration function and a control function, which are used for orchestration and control of the digital twin network instance(s), and support dynamically generating the digital twin network instance(s) meeting the service requirements according to the requirements of the consumers. The digital twin network instances are run to provide digital twin network services, thereby providing digital twin network services for specific requirements, solving the data transmission overhead and delay problems, caused by the centralized digital twin network in the actual application process, by distributed deployment of digital twin network instances.

### BRIEF DESCRIPTION OF THE DRAWINGS

FIG. 1 is a first schematic flowchart of a method for digital twin network construction according to an embodiment of the present disclosure.
FIG. 2 is a schematic diagram of a connection relationship and an interaction relationship between instances in a method for digital twin network construction according to an embodiment of the present disclosure.
FIG. 3 is a second schematic flowchart of a method for digital twin network construction according to an embodiment of the present disclosure.
FIG. 4 is a schematic flowchart of a method for digital twin network function architecture according to an embodiment of the present disclosure.
FIG. 5 is a schematic interaction flowchart of a method for digital twin network construction according to an embodiment of the present disclosure.
FIG. 6 is a first schematic diagram of the composition and structure of an apparatus for digital twin network construction according to an embodiment of the present disclosure.
FIG. 7 is a second schematic diagram of the composition and structure of an apparatus for digital twin network construction according to an embodiment of the present disclosure.
Fig. 8 is a schematic diagram of the hardware composition structure of a network function according to an embodiment of the present disclosure.

### DETAILED DESCRIPTION

The disclosure will be further elaborated below in combination with accompanying drawings and specific embodiments.

The technical solution of the embodiment of the present disclosure can be applied to various communication systems, such as a Global System of Mobile Communication (GSM) System, a Long Term Evolution (LTE) System, a 5th Generation Mobile Communication Technology (5G) System, and the like. Alternatively, the 5G system or 5G network may also be referred to as a New Radio (NR) system or NR network.

Exemplarily, the communication system to which the embodiment of the present disclosure applies may include a network device and a terminal device (also referred to as a terminal, a communication terminal, or the like). The network device may be a device that communicates with a terminal device. The access network device may provide communication coverage for a certain area and may communicate with terminal device(s) located within the area. Alternatively, the network device may be a base station in various communication systems, such as an Evolutionary Node B (eNB) in an LTE system, or a base station (the next Generation Node B (gNB)) in a 5G system or an NR system.

It should be understood that, in the embodiments of the present disclosure, a device having a communication function in the network/system may be referred to as a communication device. The communication device may include a network device and terminal having a communication function, and the network device and the terminal device may be specific devices described above, which will not be described again here. The communication device may also include other devices in the communication system, for example, other network entities such as a network controller, a mobile management entity and the like, which is not limited in the embodiments of the present disclosure.

It should be understood that, the terms "system" and "network" are often used interchangeably herein. Herein, the term "and/or" is only an association relationship describing associated objects, and means that there may be three relationships, for example, A and/or B, which may mean that A alone exists, A and B simultaneously exist, and B alone exists. In addition, the character "/" herein generally indicates that the related objects before and after this character are in an "or" relationship.

The terms "first", "second" and the like in the description and claims of the present disclosure are used to distinguish similar objects and are not necessarily used to describe a specific order or sequence. It should be understood that the data used in this way may be interchanged where appropriate, so that the embodiments of the present disclosure described herein can, for example, be implemented in an order other than those illustrated or described herein. In addition, the terms "comprising" and "having" and any variations thereof are intended to cover a non-exclusive inclusion, e.g., a process, method, system, product, or apparatus comprising a series of steps or units is not necessarily limited to those steps or units explicitly listed, but may include other steps or units that are not explicitly listed or inherent to such processes, methods, products, or apparatuses.

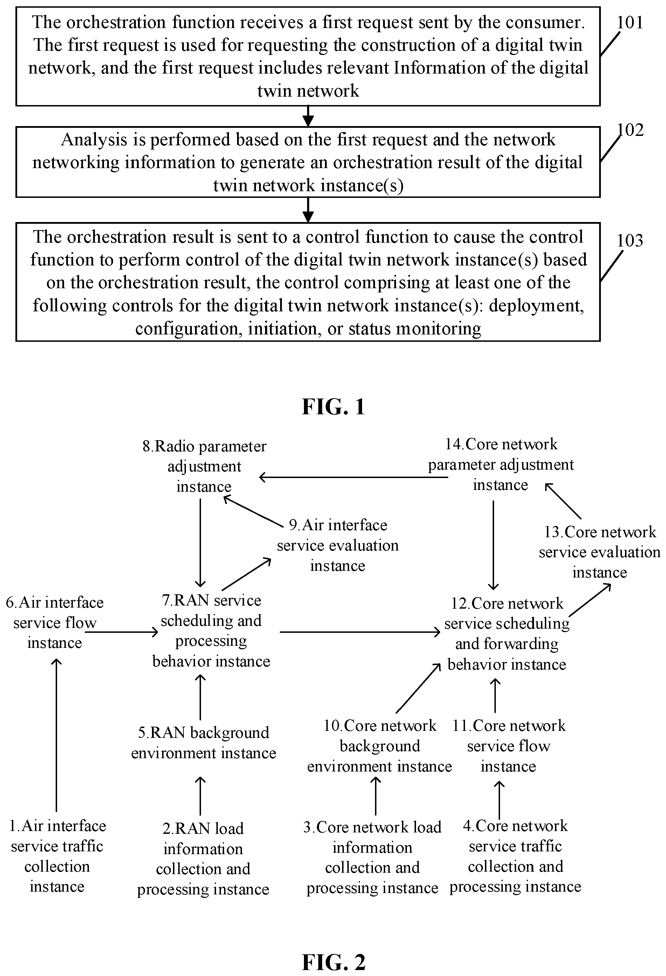

Embodiments of the present disclosure provide a method for digital twin network construction. FIG. 1 is a first schematic flowchart of a method for digital twin network construction according to an embodiment of the present disclosure. As shown in FIG. 1, the method includes the following steps.

At step 101, the orchestration function receives a first request sent by the consumer. The first request is used for requesting the construction of a digital twin network, and the first request includes relevant information of the digital twin network.

At step 102, analysis is performed by the orchestration function based on the first request and the network networking information to generate an orchestration result of the digital twin network instance(s).

At step 103, the orchestration result is sent by the orchestration function to a control function to cause the control function to perform control of the digital twin network instance(s) based on the orchestration result, the control comprising at least one of the following controls for the digital twin network instance(s): deployment, configuration, initiation, or status monitoring.

The method for the digital twin network construction of the present embodiment is applied to an orchestration function. The orchestration function may also be referred to as a digital twin orchestration function, and its main function is to orchestrate related instances of the digital twin network.

In the present embodiment, the orchestration function receives a digital twin network construction request (i.e., a first request) from a consumer, orchestrates relevant instances of the digital twin network according to the information carried in the first request, and generates an orchestration result of the digital twin network instance(s).

In some optional embodiments, the first request includes relevant information of the digital twin network, and the relevant information of the digital twin network may on the one hand include relevant information of the constructed digital twin network, for example, it may include at least one of the following information: a digital twin target network identifier, a target time period, a target service identifier (ID), a target service model and traffic volume, etc. The target network identifier is a target network determined to be twinned, and the target network may be an end-to-end network or a part of an end-to-end network. The target time period refers to a certain time period in the past, present and future of the target network to be digitally twinned. The target service ID identifies a service or a combination of services running on a target network to be digitally twinned. The target service model and traffic volume refer to the traffic model and traffic volume of the service running on the digitally twinned target network. For example, the target service model can be reflected by the traffic model identifier of the service, and the traffic volume can be reflected by the specific value, numerical threshold or numerical range of the size of the traffic volume. Optionally, the relevant information of the constructed digital twin network represents or indicates, for example, the construction of digital twin network oriented to extended reality (XR) service guarantee. On the other hand, the relevant information of the digital twin network may further include relevant information of nodes or objects that have an interactive relationship with the constructed digital twin network. Here, the node or object having an interactive relationship with the digital twin network refers to, for example, a consumer who sends the first request, and may also refer to a user node or object of the digital twin network, a source data node of the digital twin network, or the like. The relevant information of the nodes or objects having an interactive relationship with the constructed digital twin network may refer to location information (such as geographical location information) of the nodes or objects having an interactive relationship with the digital twin network.

In the present embodiment, after receiving the first request, the orchestration function can perform analysis based on the information in the first request and the network networking information, and generate an orchestration result. The network networking information specifically refers to networking information of a physical network, and may include, for example, functions or types of various network nodes, a connection relationship among the network nodes, and location information of various network nodes.

In some optional embodiments, the orchestration function may determine the digital twin network instance(s) required by the digital twin network according to the relevant information of the digital twin network in the first request, and a connection relationship and interaction relationship of various digital twin network instances, and determine deployment location(s) according to the digital twin network instance(s) determined based on the network networking information. In other optional embodiments, after the orchestration function determines the digital twin network instance(s) required for the digital twin network, the orchestration function may also determine the deployment location according to the network networking information and the relevant information of the nodes or objects that have an interactive relationship with the constructed digital twin network, for example, the relevant digital twin network instance(s) may be deployed at location(s) close to the nodes or objects that have an interactive relationship with the digital twin network, or the like.

In some optional embodiments, the orchestration function may determine digital twin network instance(s) required for the digital twin network based on the relevant information of the digital twin network in the first request in combination with the twin model of the digital twin network already in the model library.

In some optional embodiments, the consumer may be implemented through a network function, or may be implemented through a network entity or node. The orchestration function may directly receive the first request sent by the consumer, or the orchestration function may also receive the first request sent by the consumer through the network management interface.

In the present embodiment, after the orchestration function obtains the orchestration result, the orchestration result is sent to the control function, and the control function performs relevant control processing on the digital twin network instance(s) based on the orchestration result. The control function can also be called the digital twin control function, and its main function is to control and manage the whole life cycle of the digital twin network instance(s) based on the orchestration result of the digital twin network.

In some optional embodiments, the digital twin network instance(s) includes digital twin network function instance(s) and data collection and processing instance(s). The orchestration result includes at least one digital twin network function instance, at least one data collection and processing instance, and at least one of the following connection relationships and interaction relationships: a connection relationship and interaction relationship between the digital twin network function instances(s), a connection relationship and interaction relationship between the data collection and processing instance(s), and a connection relationship and interaction relationship between the digital twin network function instance(s) and the data collection and processing instance(s). In other optional embodiments, the orchestration result may further include information such as the deployment locations of various digital twin network instances.

In this embodiment, the digital twin network instance is an execution entity of the digital twin network, which can execute corresponding processing according to corresponding functions. In the present embodiment, the digital twin network instance(s) includes digital twin network function instance(s) and data collection and processing instance(s). The data collection and processing instance is mainly used for data collection and the transmission of the collected data. The digital twin network function instance is mainly used to realize the corresponding network function. The digital twin network instances cooperate with each other to jointly realize the required digital twin network, that is, to realize the virtual network mirror oriented to service requirements.

In some optional embodiments, the digital twin network function instance may specifically be a twin instance that simulates at least partial function of one network element or network function in a communication network, or may also be a twin instance that simulates a joint function of a plurality of network elements or network functions in a communication network. The digital twin network function instance(s) includes, for example, an access and mobility management function (AMF) registration processing instance, a session management function (SMF) session creation processing instance, a user plane function (UPF) flow processing instance, a combination instance of a plurality of network functions, and the like, and also, for example, a twin instance simulating a network traffic flow model, a twin instance simulating a terminal behavior model, and the like.

For example, taking the construction of a core network digital twin network oriented to XR service guarantee as an example, the data collection and processing instance(s) may include the following.
1. Air interface service traffic collection instance, which is used for generating air interface service traffic consistent with the current network XR service. The instance may be deployed at a location near the Radio Access Network (RAN) side. 2. RAN load information collection and processing instance, which is used to generate a RAN background environment consistent with the current RAN performance state. The instance is deployed at location near the RAN side node. 3. Core network load information collection and processing instance, which is used to generate a core network background environment consistent with the current network performance state. The instance may be deployed at a location near the core network function node. 4. Core network service traffic collection and processing instance, which is used for generating core network service traffic consistent with the current network XR service. This instance is deployed at a location near the UPF.

The digital twin network function instance(s) may include the following.

5. RAN background environment instance generated based on the collected RAN load information. 6. Air interface service flow instance constructed based on the input of the air interface service traffic collection instance and the service flow mapping model. 7. RAN scheduling and processing behavior instance constructed based on the air interface resource scheduling and forwarding model. 8. Radio parameter adjustment instance constructed based on radio parameter adjustment model. 9. Air interface service evaluation instance constructed based on the air interface service evaluation model. 10. Core network background environment instance generated based on the core network load information. 11. Core network service flow instance constructed based on the input of the core network service traffic collection instance and the core network service flow mapping model. 12. Core network service scheduling and forwarding behavior instance constructed based on the flow characteristic behavior model of the core network. 13, Core network service evaluation instance constructed based on the core network service evaluation model. 14. Core network parameter adjustment instance constructed based on the core network parameter adjustment model. Examples of connections and interactions between instances are shown in Figure 2.

In some optional embodiments of the present disclosure, the method further includes: the orchestration function receives a second request sent by the consumer, and sends the second request to the control function, the second request being used for requesting deletion of the digital twin network instance(s).

In the present embodiment, the orchestration function receives a digital twin network deletion request (i.e., the second request) from a consumer, and the orchestration function sends the second request to the control function, so that the control function deletes the deployed, configured, and initiated digital twin network instance(s) according to the second request.

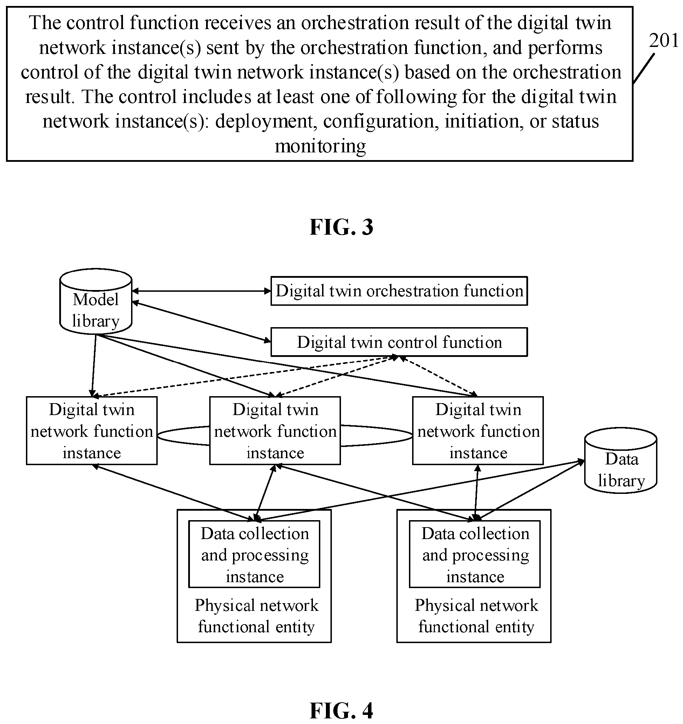

Based on the above-described embodiments, embodiments of the present disclosure also provide a method for digital twin network construction. FIG. 3 is a second schematic flowchart of a method for digital twin network construction according to an embodiment of the present disclosure. As shown in FIG. 3, the method comprises the following steps.

At step 201, the control function receives an orchestration result of the digital twin network instance(s) sent by the orchestration function, and perform control of the digital twin network instance(s) based on the orchestration result. The control includes at least one of following for the digital twin network instance(s): deployment, configuration, initiation, or status monitoring.

The method for the digital twin network construction of the present embodiment is applied to a control function. The control function can also be referred to as a digital twin control function, and the main function of the control function is to control and manage the whole life cycle of the digital twin network instance(s) based on the orchestration result of the digital twin network.

In the present embodiment, after receiving the orchestration result sent by the orchestration function, the control function deploys, configures and initiates the digital twin network instance(s) based on the orchestration result. It is also possible to monitor the statuses of various digital twin network instances after the various digital twin network instances are initiated.

The control function deploys the digital twin network instance(s), which may specifically be that the control function deploys the twin model(s) corresponding to various digital twin network instances at designated deployment position(s). Specifically, a twin model may be transmitted to a corresponding deployment position through message or signaling, so that the network element or the twin object where it is located can run the twin model. The control function configures the digital twin network instance(s),which may specifically be the attribute parameters of the twin models corresponding to various digital twin network instances, and the configuration of the connection relationship and interaction relationship between the digital twin network instances, the environment information required for running, and the like, so that the network element or the twinned object where the digital twin network instance is located can normally run the twin model and realize the interaction between various digital twin network instances. The operation that the control function performs initiation of the digital twin network instance(s) may specifically be that the control function initiates or runs each digital twin network instance through instruction or signaling.

In some optional embodiments, the digital twin network instance(s) includes digital twin network function instance(s) and data collection and processing instance(s). The orchestration result includes at least one digital twin network function instance, at least one data collection and processing instance, and at least one of following: a connection relationship and interaction relationship between the digital twin network function instance(s), a connection relationship and interaction relationship between the data collection and processing instance(s), and a connection relationship and interaction relationship between the digital twin network function instance(s) and the data collection and processing instance(s).

In this embodiment, the digital twin network instance is an execution entity of the digital twin network, which can execute corresponding processing according to corresponding functions. In the present embodiment, the digital twin network instance(s) includes digital twin network function instance(s) and data collection and processing instance(s). The data collection and processing instance is mainly used for data collection and the transmission of the collected data. The digital twin network function instance is mainly used to realize the corresponding network function. The digital twin network instances cooperate with each other to jointly realize the required digital twin network, that is, to realize the virtual network mirror oriented to service requirements.

In some optional embodiments, the digital twin network function instance may specifically be a twin instance that simulates at least partial function of one network element or network function in a communication network, or may also be a twin instance that simulates a joint function of a plurality of network elements or network functions in a communication network. The digital twin network function instance may be, for example, an AMF registration processing instance, an SMF session creation processing instance, an UPF flow processing instance, a combination instance of a plurality of network functions, or the like. For another example, the digital twin network function instance may be a twin instance simulating a network traffic flow model, a twin instance simulating a terminal behavior model, or the like.

For example, taking the construction of a core network digital twin network oriented to XR service guarantee as an example, the data collection and processing instance(s) may include the following.
1. Air interface service traffic collection instance, which is used for generating air interface service traffic consistent with the current network XR service. The instance may be deployed at a location near the RAN side. 2. RAN load information collection and processing instance, which is used to generate a RAN background environment consistent with the current RAN performance state. The instance is deployed at location near the RAN side node. 3. Core network load information collection and processing instance, which is used to generate a core network background environment consistent with the current network performance state. The instance may be deployed at a location near the core network function node. 4. Core network service traffic collection and processing instance, which is used for generating core network service traffic consistent with the current network XR service. This instance is deployed at a location near the UPF.

The digital twin network function instance(s) may include the following.

5. RAN background environment instance generated based on the collected RAN load information. 6. Air interface service flow instance constructed based on the input of the air interface service traffic collection instance and the service flow mapping model. 7. RAN scheduling and processing behavior instance constructed based on the air interface resource scheduling and forwarding model. 8. Radio parameter adjustment instance constructed based on radio parameter adjustment model. 9. Air interface service evaluation instance constructed based on the air interface service evaluation model. 10. Core network background environment instance generated based on the core network load information. 11. Core network service flow instance constructed based on the input of the core network service traffic collection instance and the core network service flow mapping model. 12. Core network service scheduling and forwarding behavior instance constructed based on the flow characteristic behavior model of the core network. 13, Core network service evaluation instance constructed based on the core network service evaluation model. 14. Core network parameter adjustment instance constructed based on the core network parameter adjustment model. Examples of connections and interactions between instances are shown in Figure 2.

In some optional embodiments of the present disclosure, the operation that the control function performs deployment of the digital twin network instance(s) based on the orchestration result comprises: the control function obtains twin model(s) corresponding to the digital twin network instance(s) based on the orchestration result, and determines deployment position(s) of the digital twin network instance(s). The control function deploys the digital twin network instance(s) in accordance with the deployment location(s) and the twin model(s).

In the present embodiment, the control function may obtain twin model(s) required for constructing a digital twin network based on the orchestration result. In some optional embodiments, the control function may obtain the required twin model(s) from the model library or may obtain the required twin model(s) through the online learning model in the running digital twin instance.

The control function deploys the acquired twin model at the deployment location of the corresponding digital twin network instance. In other optional embodiments, if the orchestration result further includes the deployment locations corresponding to various digital twin network instances, the control function deploys the digital twin network instances in accordance with the deployment locations. In other optional embodiments, if the orchestration result does not include the deployment locations corresponding to various digital twin network instances, the control function may deploy the digital twin network instances and the twinned objects nearby according to factors such as the digital twin network requirements and data transmission costs, or may deploy them in a centralized or hierarchical manner at appropriate locations. Optionally, the orchestration result may also carry relevant information (such as location information) of nodes or objects having an interactive relationship with the constructed digital twin network, and the control function may determine the deployment positions corresponding to various digital twin network instances according to the location information. Furthermore, the control function deploys the corresponding twin models at the corresponding deployment positions through message or signaling according to the determined deployment positions.

In some optional embodiments of the present disclosure, the operation that the control function performs configuration of the digital twin network instance(s) based on the orchestration result comprises: the control function configures at least one of the following to the digital twin network instance(s) based on the orchestration result: connection relationship and interaction relationship between digital twin network instances; or attribute information of the data collection processing instance(s).

In the present embodiment, on the one hand, the operation that the control function performs configuration of the digital twin network instances may specifically comprises that the control function configures the connection relationship and the interaction relationship between the digital twin network instances, such as the connection relationship and the interaction relationship between each digital twin network instance shown in FIG. 2. The control function may send messages or signaling to each digital twin network instance, and configure the connection relationship and the interaction relationship between the digital twin network instances through the messages or signaling. On the other hand, the control function also needs to configure the attribute information of the digital twin network instances. For example, for the data collection and processing instance, the configuration of related attributes thereof may include at least one of the following: collection range, content, collection frequency, reporting frequency, output object, and the like. For another example, for the digital twin network functional instance, its associated attribute parameters may also be configured. In other optional embodiments, the control function may also configure operating environment information of various digital twin network instances, and the like. Of course, other parameters related to the running of the digital twin network instance also need to be configured by the control function, which is not limited in this embodiment.

In some optional embodiments, when the existing data collection and processing instance can meet the data collection requirements, the control function may update based on the configuration of the existing data collection and processing instance to meet the requirements of the digital twin instance.

In some optional embodiments of the present disclosure, the operation that the control function performs initiation of the digital twin network instance(s) based on the orchestration result comprises: the control function sends a first instruction to the digital twin network instance(s). The first instruction is used to initiate the digital twin network instance(s).

In the present embodiment, after the configuration work is completed, the control function initiates the digital twin network instance(s). Specifically each digital twin network instance may be initiated or run by instruction or signaling. Multiple digital twin network instances operate together and interact with information to realize the digital twin network needed by the consumer.

In some optional embodiments of the present disclosure, the operation that the control function performs status monitoring of the digital twin network instance(s) based on the orchestration result comprises: the control function obtains status information sent by the digital twin network instance(s), and monitors the status of the digital twin network instance(s) based on the status information.

In the present embodiment, the control function can perform information interaction with each digital twin network instance, for example, the digital twin network instance can report information according to a specified policy (for example, periodicity, or reporting when an abnormality is detected), the control function receives the information reported by the digital twin network instance(s), thereby determining the status information of the digital twin network instance(s), and monitoring the status of the digital twin network instance(s) based on the status information.

In some optional embodiments of the present disclosure, the method further comprises: the control function receives a second request sent by the orchestration function. The second request is used for requesting deletion of the digital twin network instance(s). The control function sends a second instruction to the digital twin network instance(s) based on the second request, and the second instruction is used to stop running the digital twin network instance(s) and reclaim resources of the digital twin network instance(s).

In this embodiment, the orchestration function receives a digital twin network deletion request (i.e., a second request) from a consumer. The orchestration function sends the second request to the control function, and after receiving the second request, the control function deletes the deployed, configured, and initiated digital twin network instances according to the second request, which may specifically be achieved by sending a message or instruction to each digital twin network instance. The deployed, configured, and initiated digital twin network instances are deleted through the message or instruction, and the resource(s) of the digital twin network instance(s) are reclaimed.

FIG. 4 is a schematic diagram of a functional architecture of a digital twin network according to an embodiment of the present disclosure. As shown in FIG. 4, the architecture includes a digital twin orchestration function (i.e., orchestration function) and a digital twin control function (i.e., control function). The digital twin orchestration function may orchestrate the digital twin network instances according to the construction requirements of the digital twin network, the existing twin models related to the digital twin and the networking information of the physical network, and generate the orchestration result. The digital twin control function controls and manages the whole life cycle of the digital twin network instance(s) based on the orchestration result of the digital twin network instance(s). Both the digital twin orchestration function and the digital twin control function may interact with the model library, and the digital twin orchestration function may learn the relevant information of the existing twin models related to the digital twin through the model library, so as to generate the orchestration result. The digital twin control function may obtain relevant twin models from the model library based on the orchestration result to perform relevant control of subsequent digital twin network instances.

The digital twin network instance is an execution entity of the digital twin network, and may include digital twin network function instance and data collection and processing instance. The data collection and processing instance is used to collect data and transmit the collected data. The digital twin network function instance is mainly used to realize the corresponding network function. The digital twin network instances cooperate with each other to jointly realize the required digital twin network, that is, to realize the virtual network mirror oriented to service requirements.

The embodiment of the present disclosure proposes an orchestration function and a control function for orchestration and control of digital twin network instances, which supports dynamic generation of digital twin network instances meeting service requirements according to the requirements of the consumers. The digital twin network instances are run to provide digital twin network services, thereby providing digital twin network services for specific requirements, solving the data transmission overhead and delay problems, caused by the centralized digital twin network in the actual application process, by distributed deployment of digital twin network instances. In addition, the technical solutions of the embodiment of the present disclosure improve the resource utilization rate while meeting service requirements.

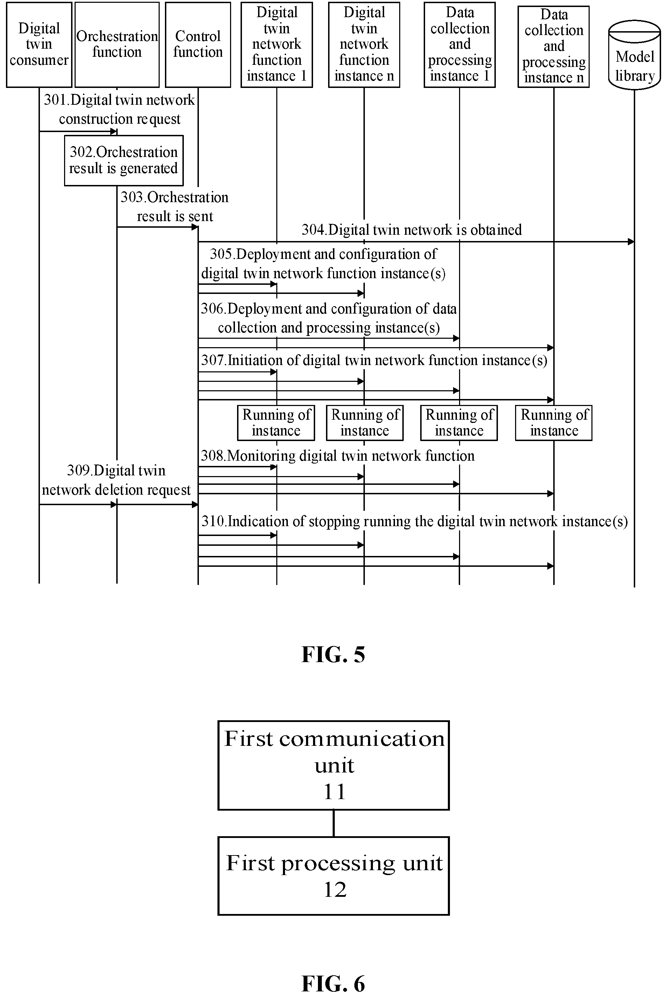

FIG. 5 is a schematic interaction flowchart of a method for digital twin network construction according to an embodiment of the present disclosure. As shown in FIG. 5, the method comprises the following steps.

At step 301, the digital twin consumer sends a digital twin network construction request to the orchestration function.

Here, the digital twin network construction request includes relevant information of the digital twin network, and the relevant information of the digital twin network may include, on the one hand, relevant information of the constructed digital twin network. For example, it may include at least one of the following information: a the digital twin target network identifier, a target time period, a target service identifier (ID), a target service model, a traffic volume, and the like. The target network identifier is a target network determined to be twinned, and the target network may be an end-to-end network or a part of an end-to-end network. The target time period refers to a certain time period in the past, present and future of the target network to be digitally twinned. The target service ID identifies a service or a combination of services running on a target network to be digitally twinned. The target service model and traffic volume refer to the traffic model and traffic volume of the service running on the digitally twinned target network. For example, the target service model can be reflected by the traffic model identifier of the service, and the traffic volume can be reflected by the specific value, numerical threshold or numerical range of the size of the traffic volume. Optionally, the relevant information of the constructed digital twin network represents or indicates, for example, construction of a digital twin network oriented to XR service guarantee. On the other hand, the relevant information of the digital twin network may further include relevant information of nodes or objects that have an interactive relationship with the constructed digital twin network. Here, the node or object having an interactive relationship with the digital twin network refers to, for example, a consumer who sends the first request, and may also refer to a user node or object of the digital twin network, a source data node of the digital twin network, or the like. The relevant information of the nodes or objects having an interactive relationship with the constructed digital twin network may refer to location information (such as geographical location information) of the nodes or objects having an interactive relationship with the digital twin network.

At step 302, the orchestration function analyses digital twin network construction request, the twin model(s) of the existing digital twin network and the network networking information, and generates the orchestration result of the digital twin network instance(s).

Here, the orchestration function performs comprehensive analysis based on the construction requirements of the digital twin network, model(s) related to the existing digital twin network and the networking information of the physical network, and generates the orchestration result of the digital twin network instance(s). The orchestration function can specifically determine the digital twin network instance(s) required for the digital twin network, the connection relationship and the interaction relationship of various digital twin network instances according to the relevant information of the digital twin network in the construction requirement, and determine the deployment position according to the digital twin network instance(s) determined based on the network networking information. In other optional embodiments, after the orchestration function determines the digital twin network instance(s) required for the digital twin network, the orchestration function may also determine the deployment location according to the network networking information and the relevant information (such as the location information) of the nodes or objects that have an interactive relationship with the constructed digital twin network, for example, the relevant digital twin network instance(s) may be deployed at location(s) close to the nodes or objects that have an interactive relationship with the digital twin network, or the like. Nodes having an interactive relationship with the digital twin network may be, for example, source data nodes of the digital twin network, consumer nodes of the digital twin network, and the like.

The orchestration result may include: at least one digital twin network function instance, at least one data collection and processing instance, and at least one of the following: a connection relationship and interaction relationship between the digital twin network function instance(s), a connection relationship and interaction relationship between the data collection and processing instance(s), and a connection relationship and interaction relationship between the digital twin network function instance(s) and the data collection and processing instance(s). In other optional embodiments, the orchestration result may further include information such as the deployment locations of various digital twin network instances. The digital twin network function instance may be, for example, an AMF registration processing instance, an SMF session creation processing instance, an UPF flow processing instance, a combination instance of a plurality of network functions, or the like. For another example, the digital twin network function instance may be a twin instance simulating a network traffic flow model, a twin instance simulating a terminal behavior model, or the like.

For example, taking the construction of a core network digital twin network oriented to XR service guarantee as an example, the data collection and processing instance(s) may include the following.
1. Air interface service traffic collection instance, which is used for generating air interface service traffic consistent with the current network XR service. The instance may be deployed at a location near the RAN side. 2. RAN load information collection and processing instance, which is used to generate a RAN background environment consistent with the current RAN performance state. The instance is deployed at location near the RAN side node. 3. Core network load information collection and processing instance, which is used to generate a core network background environment consistent with the current network performance state. The instance may be deployed at a location near the core network function node. 4. Core network service traffic collection and processing instance, which is used for generating core network service traffic consistent with the current network XR service. This instance is deployed at a location near the UPF.

The digital twin network function instance(s) may include the following.

5. RAN background environment instance generated based on the collected RAN load information. 6. Air interface service flow instance constructed based on the input of the air interface service traffic collection instance and the service flow mapping model. 7. RAN scheduling and processing behavior instance constructed based on the air interface resource scheduling and forwarding model. 8. Radio parameter adjustment instance constructed based on radio parameter adjustment model. 9. Air interface service evaluation instance constructed based on the air interface service evaluation model. 10. Core network background environment instance generated based on the core network load information. 11. Core network service flow instance constructed based on the input of the core network service traffic collection instance and the core network service flow mapping model. 12. Core network service scheduling and forwarding behavior instance constructed based on the flow characteristic behavior model of the core network. 13, Core network service evaluation instance constructed based on the core network service evaluation model. 14. Core network parameter adjustment instance constructed based on the core network parameter adjustment model. Examples of connections and interactions between instances are shown in Figure 2.

At step 303, the orchestration function sends the orchestration result to the control function. The control function can deploy, configure, initiate and manage the whole life cycle of the digital twin network function instance and data collection and processing instance based on the orchestration result.

At step 304, the control function acquires the twin model(s) from the model library based on the orchestration result.

The control function may obtain the required twin model(s) from the model library or may obtain the required twin model(s) through the online learning model in the running digital twin instance.

At step 305, the control function deploys and configures the digital twin network function instance(s).

Here, the control function may deploy the digital twin network instance(s) and the twinned object(s) nearby according to factors such as the orchestration result and data transmission costs, or may deploy them in a centralized or hierarchical manner at appropriate locations. After the deployment location is determined, the twin model(s) corresponding to the acquired digital twin network function instance(s) is deployed through signaling or message, and information such as association information and running environment among the digital twin network function instance(s) is configured.

At step 306, control function deploys and configures data collection processing instance(s).

Here, the control function may determine the deployment location of the data collection and processing instance according to the orchestration result. Exemplarily, data collection and processing instances are normally deployed near the data source. After the deployment location is determined, the twin model corresponding to the acquired data collection and processing instance is deployed through signaling or message, and the relevant information of the data collection and processing instance and the association information between the data collection and processing instance and the digital twin network function instance are configured. The configuration of the relevant information of the data collection and processing instance includes, for example, the configuration of the relevant attributes of the data collection and processing instance, which include collection range, content, collection frequency, reporting frequency, output object, and the like.

Optionally, when the existing data collection and processing instance can meet the data collection requirements, the control function may update based on the configuration of the existing data collection and processing instance, that is, send a message or instruction to the existing data collection and processing instance, and the message or instruction includes the updated configuration information, so as to meet the needs of the digital twin instance.

At step 307, the control function initiates various digital twin network instances.

After the preparation of the configuration deployment is completed, the control function initiates all the corresponding digital twin function instances.

Step 308, the control function monitors the status of each digital twin network instance.

Here, the control function can perform information interaction with each digital twin network instance, for example, the digital twin network instance can report information according to a specified policy (for example, periodicity, or reporting when an abnormality is detected), the control function receives the information reported by the digital twin network instance(s), so as to determine the status information of the digital twin network instance(s), monitor the status of the digital twin network instance(s) based on the status information, and promptly handle and optimize when an abnormality is detected.

At step 309, the digital twin consumer sends a digital twin network deletion request to the orchestration function, and the orchestration function sends the digital twin network deletion request to the control function.

At step 310, the control function sends an instruction to each digital twin network instance to instruct to stop running the digital twin network instance(s) and reclaim resource(s) of the digital twin network instance.

Based on the above described embodiments, an embodiment of the present disclosure provides an apparatus for digital twin network construction, and the apparatus is applied to an orchestration function. FIG. 6 is a first schematic diagram of the composition and structure of an apparatus for digital twin network construction according to an embodiment of the present disclosure. As shown in FIG. 6, the apparatus comprises a first communication unit 11 and a first processing unit 12.

The first communication unit 11 is configured to receive a first request sent by the consumer. The first request is used for requesting construction of a digital twin network 11, and the first request comprises relevant information of the digital twin network.

The first processing unit 12 is configured to perform analysis based on the first request and network networking information to generate an orchestration result of digital twin network instance(s).

The first communication unit 11 is further configured to send the orchestration result to a control function to cause the control function to perform control of the digital twin network instance(s) based on the orchestration result, the control comprising at least one of following controls for the digital twin network instance(s): deployment, configuration, initiation, or status monitoring.

In some optional embodiments of the present disclosure, the first communication unit 11 is further configured to receive a second request sent by the consumer, and send the second request to the control function, the second request being used for requesting deletion of the digital twin network instance(s).

In some optional embodiments of the present disclosure, the digital twin network instance(s) comprises: digital twin network function instance(s) and data collection and processing instance(s).

The orchestration result comprises: at least one digital twin network function instance, at least one data collection and processing instance, and at least one of following: a connection relationship and interaction relationship between the digital twin network function instance(s), a connection relationship and interaction relationship between the data collection and processing instance(s), and a connection relationship and interaction relationship between the digital twin network function instance(s) and the data collection and processing instance(s).

In the embodiment of the present disclosure, the first processing unit 12 in the apparatus may be realized by a Central Processing Unit (CPU), a Digital Signal Processor (DSP), a Microcontroller Unit (MCU), or a Field-Programmable Gate Array (FPGA) in practical applications. In practical applications, the first communication unit 11 in the apparatus can be realized by a communication suite (including a basic communication suite, an operating system, a communication module, a standardized interface and protocol, etc.) and a transceiver antenna.

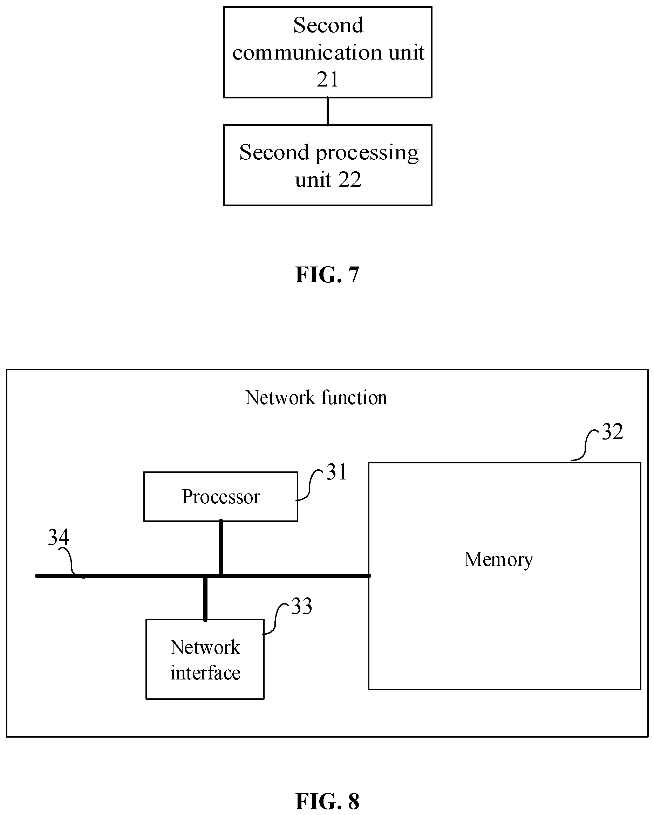

Embodiments of the present disclosure provide an apparatus for digital twin network construction, and the apparatus is applied to a control function. FIG. 7 is a second schematic diagram of the composition and structure of an apparatus for digital twin network construction according to an embodiment of the present disclosure. As shown in FIG. 7, the apparatus includes: a second communication unit 21 and a second processing unit 22.

The second communication unit 21 is configured to receive the orchestration result of the digital twin network instance(s) sent by the orchestration function.

The second processing unit 22 is configured to perform control of the digital twin network instance(s) based on the orchestration result, the control comprising at least one of following for the digital twin network instance(s): deployment, configuration, initiation, or status monitoring.

In some optional embodiments of the present disclosure, the digital twin network instance(s) comprises: digital twin network function instance(s) and data collection and processing instance(s).

The orchestration result comprises: at least one digital twin network function instance, at least one data collection and processing instance, and at least one of following: a connection relationship and interaction relationship between the digital twin network function instance(s), a connection relationship and interaction relationship between the data collection and processing instance(s), and a connection relationship and interaction relationship between the digital twin network function instance(s) and the data collection and processing instance(s).

In some optional embodiments of the present disclosure, the second processing unit 22 is configured to obtain twin model(s) corresponding to the digital twin network instance(s) based on the orchestration result, and determine deployment location(s) of the digital twin network instance(s); and is further configured to deploy the digital twin network instance(s) through the second communication unit 21 according to the deployment location(s) and the twin model(s).

In some optional embodiments of the present disclosure, the second processing unit 22 is configured to configure, through the second communication unit 21, at least one of the following to the digital twin network instance(s) based on the orchestration result: a connection relationship and interaction relationship between the digital twin network instance(s); or attribute information of data collection processing instance(s).

In some optional embodiments of the present disclosure, the second processing unit 22 is configured to send a first instruction to the digital twin network instance(s) through the second communication unit 21, and the first instruction is used to initiate the digital twin network instance(s).

In some optional embodiments of the present disclosure, the second processing unit 22 is configured to obtain, through the second communication unit 21, status information sent by the digital twin network instance(s), and monitor status of the digital twin network instance(s) based on the status information.

In some optional embodiments of the present disclosure, the second communication unit 21 is further configured to receive a second request sent by the orchestration function, the second request being used for requesting deletion of the digital twin network instance(s), and send a second instruction to the digital twin network instance(s) based on the second request, the second instruction being used to stop running the digital twin network instance(s) and reclaim resource(s) of the digital twin network instance(s).

In the embodiment of the present disclosure, the second processing unit 22 in the apparatus may be realized by a CPU, a DSP, a MCU, or a FPGA in practical applications. In practical applications, the second communication unit 21 in the apparatus can be realized by a communication suite (including a basic communication suite, an operating system, a communication module, a standardized interface and protocol, etc.) and a transceiver antenna.

It should be noted that, when the apparatus for digital twin network construction provided in the above-described embodiments constructs the digital twin network, the division of the above-described program modules is only used as an example. In practical application, the above-described processing can be allocated to be completed by different program modules as necessary, that is, the internal structure of the apparatus can be divided into different program modules to complete all or part of the above-described processing. In addition, the apparatus for digital twin network construction provided in the above-described embodiments belongs to the same concept as the method embodiments for digital twin network construction, and the specific implementation process thereof is detailed in the method embodiment, which will not be described again here.

The embodiment of the present disclosure also provides a network function, and the network function may specifically be an orchestration function or a control function. FIG. 8 is a schematic diagram of a hardware component structure of a network function according to an embodiment of the present disclosure. As shown in FIG. 8, the communication device includes a memory 32, a processor 31, and a computer program stored in the memory 32 and executable by the processor 31. When the processor 31 executes the program, the steps of a method for digital twin network construction applied to an orchestration function or a control function are realized.

Optionally, the network function further comprises at least one network interface 33. Here, the various components in the network function are coupled together by a bus system 34. It can be understood that the bus system 34 is used to enable connected communication between these components. The bus system 34 includes a power bus, a control bus, and a status signal bus in addition to a data bus. However, for clarity of explanation, the various buses are designated as bus systems 34 in FIG. 8.

It is understood that the memory 32 may be a volatile memory or a non-volatile memory, or may include both volatile and non-volatile memory. The non-volatile memory may be a Read-Only Memory (ROM), a Programmable Read-Only Memory (PROM), an Erasable Programmable Read-Only Memory (EPROM), an Electrically Erasable Programmable Read-Only Memory (EEPROM), a Ferromagnetic Random Access Memory (FRAM), a flash memory, a magnetic surface memory, an optical disc, or a read-only disc (Compact Disc Read-Only Memory, CD-ROM). The magnetic surface memory may be a magnetic disk memory or a magnetic tape memory. The volatile memory may be a Random Access Memory (RAM), which serves as an external cache. By way of example, but not limitation, many forms of RAM are available, such as Static Random Access Memory (SRAM), Synchronous Static Random Access Memory (SSRAM), Dynamic Random Access Memory (DRAM), Synchronous Dynamic Random Access Memory (SDRAM), Double Data Rate Synchronous Dynamic Random Access Memory (DDRSDRAM), Enhanced Synchronous Dynamic Random Access Memory (ESDRAM), Synchronously connect Dynamic Random Access Memory (SLDRAM) and Direct Rambus Random Access Memory (DRRAM). The memory 32 described in embodiments of the present disclosure is intended to include, but is not limited to, these and any other suitable types of memory.

The method disclosed in the above-described embodiment of the present disclosure may be applied to the processor 31 or implemented by the processor 31. The processor may be an integrated circuit chip having signal processing capabilities. In the implementation process, the steps of the above-described methods may be completed by integrated logic circuits of hardware in the processor 31 or instructions in the form of software. The processor 31 described above may be a general-purpose processor, a DSP, or other programmable logic devices, discrete gate or transistor logic devices, discrete hardware components, or the like. The processor 31 may implement or execute the methods, steps, and logical block diagrams disclosed in the embodiments of the present disclosure. The general purpose processor may be a microprocessor or any conventional processor or the like. The steps of the method disclosed in connection with the embodiments of the present disclosure may be directly embodied as execution by the hardware decoding processor, or may be executed by combining hardware and software modules in the decoding processor. The software modules are located in the storage medium, which is located in the memory 32, and the processor 31 reads the information in the memory 32, and combines its hardware to complete the steps of the above methods.

In an exemplary embodiment, network functions may be implemented by one or more Application Specific Integrated circuits (ASICs), DSPs, Programmable Logic devices (PLDs), Complex Programmable Logic devices (CPLDs), FPGAs, general purpose processors, controllers, MCUs, microprocessors, or other electronic components for performing the foregoing methods.

In an exemplary embodiment, embodiments of the present disclosure also provide a computer-readable storage medium, such as a memory 32 including a computer program executable by a processor 31 of a network function to complete the steps described in the aforementioned method. The computer-readable storage medium may be a memory such as FRAM, ROM, PROM, EPROM, EEPROM, flash memory, magnetic surface memory, optical disk, or CD-ROM, or may be various devices including one or any combination of the above-described memories.

The computer-readable storage medium provided by the embodiment of the present disclosure has a computer program stored thereon, and when the program is executed by a processor, the steps of a method for digital twin network construction applied to an orchestration function or a control function according to the embodiment of the present disclosure are realized.

The methods disclosed in several method embodiments provided in the present disclosure can be arbitrarily combined without conflict to obtain new method embodiments.

The features disclosed in several product embodiments provided in the present disclosure can be arbitrarily combined without conflict to obtain new product embodiments.

The features disclosed in several method or apparatus embodiments provided in the present disclosure can be arbitrarily combined without conflict to obtain a new method or apparatus embodiment.

In several embodiments provided herein, it should be understood that the disclosed devices and methods may be implemented in other ways. The device embodiments described above are merely schematic, for example, the division of units is only one logical function division, and there may be other division methods in actual implementation, for example, multiple units or components may be combined or integrated into another system, or some features may be ignored or not implemented. In addition, the coupling or direct coupling or communication connection between various components shown or discussed may be an indirect coupling or communication connection through some interface, device or unit, which may be electrical, mechanical or otherwise.

The units described as separate units may or may not be physically separate, and the units displayed as units may or may not be physical units, that is, they may be located in one place or may be distributed over a plurality of network units. Some or all of the units can be selected according to actual needs to achieve the purpose of the solution of the present embodiment.

In addition, each functional unit in embodiments of the present disclosure may be integrated in one processing unit. Each unit may be separately used as one unit, or two or more units may be integrated into one unit. The above integrated unit may be realized in the form of hardware or hardware plus software functional unit.

Those of ordinary skill in the art can understand that all or part of the steps of implementing the above-described method embodiments can be completed by hardware related to program instructions, the above-described program can be stored in a computer-readable storage medium, and when the program is executed, the steps including the above-described method embodiments are executed. The aforementioned storage medium includes various media capable of storing program code, such as a mobile storage device, a ROM, a RAM, a magnetic disk, an optical disk, or the like.

Alternatively, when the integrated unit described in the disclosure is implemented in the form of a software functional module and sold or used as an independent product, it may also be stored in a computer-readable storage medium. Based on such an understanding, the technical solutions according to embodiments of the disclosure in essence or the part contributing to the prior art can be embodied in the form of a software product, and the computer software product is stored in a storage medium, which includes several instructions so that a computer device (may be a personal computer, a server, a network device or the like) implements all or part of the method according to respective embodiments of the disclosure. The aforementioned storage medium includes various media capable of storing a program code such as a mobile storage device, an ROM, an RAM, a magnetic disk or an optical disk.

The above is merely a specific embodiment of the present disclosure, but the scope of protection of the present disclosure is not limited thereto, and any change or substitution, within the technical scope disclosed in the present application, that can be easily thought of by the person skilled in the art should be covered within the scope of protection of the present disclosure. Therefore, the scope of the present disclosure should be subject to the scope of the claims.

## Claims

1. A method for digital twin network construction, the method being applied to an orchestration function, wherein the method comprises:
receiving, by the orchestration function, a first request sent by the consumer, wherein the first request is used for requesting construction of a digital twin network, and the first request comprises relevant information of the digital twin network;
performing, by the orchestration function, analysis based on the first request and network networking information to generate an orchestration result of digital twin network instance(s); and
sending, by the orchestration function, the orchestration result to a control function to cause the control function to perform control of the digital twin network instance(s) based on the orchestration result, the control comprising at least one of following controls for the digital twin network instance(s): deployment, configuration, initiation, or status monitoring.

2. The method according to claim 1, comprising:
receiving, by the orchestration function, a second request sent by the consumer, and sending the second request to the control function, the second request being used for requesting deletion of the digital twin network instance(s).

3. The method according to claim 1, wherein the digital twin network instance(s) comprises: digital twin network function instance(s) and data collection and processing instance(s),
wherein the orchestration result comprises: at least one digital twin network function instance, at least one data collection and processing instance, and at least one of following: a connection relationship and interaction relationship between the digital twin network function instance(s), a connection relationship and interaction relationship between the data collection and processing instance(s), and a connection relationship and interaction relationship between the digital twin network function instance(s) and the data collection and processing instance(s).

4. A method for digital twin network construction, the method being applied to a control function, wherein the method comprises:
receiving ,by the control function, an orchestration result of digital twin network instance(s) sent by an orchestration function, and performing control of the digital twin network instance(s) based on the orchestration result, wherein the control comprises at least one of following for the digital twin network instance(s): deployment, configuration, initiation, or status monitoring.

5. The method according to claim 4, wherein the digital twin network instance(s) comprises: digital twin network function instance(s) and data collection and processing instance(s),
wherein the orchestration result comprises: at least one digital twin network function instance, at least one data collection and processing instance, and at least one of following: a connection relationship and interaction relationship between the digital twin network function instance(s), a connection relationship and interaction relationship between the data collection and processing instance(s), and a connection relationship and interaction relationship between the digital twin network function instance(s) and the data collection and processing instance(s).

6. The method according to claim 4 or 5, wherein the performing, by the control function, deployment of the digital twin network instance(s) based on the orchestration result comprises:
obtaining, by the control function, twin model(s) corresponding to the digital twin network instance(s) based on the orchestration result, and determining deployment location(s) of the digital twin network instance(s); and
deploying, by the control function, the digital twin network instance(s) according to the deployment location(s) and the twin model(s).

7. The method according to claim 4 or 5, wherein the performing, by the control function, configuration of the digital twin network instance(s) based on the orchestration result comprises:
configuring, by the control function, at least one of the following to the digital twin network instance(s) based on the orchestration result:
a connection relationship and interaction relationship between the digital twin network instance(s); or
attribute information of data collection processing instance(s).

8. The method according to claim 4 or 5, wherein the performing, by the control function, initiation of the digital twin network instance(s) based on the orchestration result comprises:
sending, by the control function, a first instruction to the digital twin network instance(s), the first instruction being used to initiate the digital twin network instance.

9. The method according to claim 4 or 5, wherein the performing, by the control function, status monitoring of the digital twin network instance(s) based on the orchestration result comprises:
obtaining, by the control function, status information sent by the digital twin network instance(s), and monitoring status of the digital twin network instance(s) based on the status information.

10. The method according to claim 4 or 5, comprising:
receiving, by the control function, a second request sent by the orchestration function, the second request being used for requesting deletion of the digital twin network instance(s); and
sending, by the control function, a second instruction to the digital twin network instance(s), wherein the second instruction is used to stop running the digital twin network instance(s) and reclaim resource(s) of the digital twin network instance(s).

11. An apparatus for digital twin network construction, the apparatus being applied to an orchestration function, wherein the apparatus comprise a first communication unit and a first processing unit, wherein
the first communication unit is configured to receive a first request sent by the consumer, wherein the first request is used for requesting construction of a digital twin network, and the first request comprises relevant information of the digital twin network;
the first processing unit is configured to perform analysis based on the first request and network networking information to generate an orchestration result of digital twin network instance(s); and
the first communication unit is further configured to send the orchestration result to a control function to cause the control function to perform control of the digital twin network instance(s) based on the orchestration result, the control comprising at least one of following controls for the digital twin network instance(s): deployment, configuration, initiation, or status monitoring.

12. An apparatus for digital twin network construction, the apparatus being applied to a control function, wherein the apparatus comprise a second communication unit and a second processing unit, wherein
the second communication unit is configured to receive the orchestration result of the digital twin network instance(s) sent by the orchestration function; and
the second processing unit is configured to perform control of the digital twin network instance(s) based on the orchestration result, the control comprising at least one of following for the digital twin network instance(s): deployment, configuration, initiation, or status monitoring.

13. A computer-readable storage medium, in which a computer program is stored, wherein when the program is executed by a processor, steps of the method of any one of claims 1 to 3 are implemented; or
when the program is executed by the processor, steps of the method of any one of claims 4 to 10 are implemented.

14. A network function comprising: a processor, a memory and a computer program stored in the memory and executable by the processor, wherein when the program is executed by the processor, the steps of the method of any one of claims 1 to 3 are implemented; or
when the program is executed by the processor, steps of the method of any one of claims 4 to 10 are implemented.
